# EUROPEAN PATENT APPLICATION

(11) **EP 1 265 247 A1**
(43) Date of publication of application: **11.12.2002**
(21) Application number: 01830368.5
(22) Date of filing: 05.06.2001
(51) Int. Cl.: G11C 7/10, G11C 7/22, G11C 11/4076, H03K 5/13, H03L 7/081

(54) **A programmable delay line and corresponding memory**

(71) Applicant: STMicroelectronics S.r.l., 20041 Agrate Brianza (Milano) (IT)
(72) Inventor: La Rosa, Roberto, 90145 Palermo (IT)
(74) Representative: Bosotti, Luciano

(57) **Abstract**

A programmable delay element comprises a plurality of delay modules (d, d'), which can be connected together for generating, starting from an input signal (IS), an output signal (OS) delayed with a pre-determined time-delay value referred to a given value (T) of operating period. A control logic (LC) selectively connects together the-delay modules (d, d') in such a way as to obtain the aforesaid pre-determined time-delay value. The arrangement is such that the jitter present on the delayed output signal (OS) is made to vary proportionally to the operating period (T) so as to maintain the ratio between said period (T) and said jitter substantially constant. The element is usable in particular in memories of the DDR-SDRAM type for generating the delayed DQS signal (DQS_delayed) with the possibility of varying selectively the amount of delay as a function of the frequency (T) of operation of the memory.

## Description

### Field of the invention

The present invention relates to delay lines and has been developed with particular attention paid to their possible application in the field of memories, in particular in SDRAM memories with double data rate (DDR).

### Description of the prior art

In normal SDRAM memories of the DDR type, the data and the data quadrature strobe (DQS) signal are emitted by the memory in a synchronous way and in phase with one another on the rising and falling edges.

In order to obtain an exact set-up of the data and a correct hold time at the flip-flop functioning as latch, the DQS signal must be delayed.

In particular, with a 90° delay (i.e., one quarter of the period of the signals considered) and with an accurate delay of the DQS signal at the rising and falling edges, it is possible, according to the frequency range of the DQS and the performance of the flip-flop, to obtain an ample margin of tolerance both for the set-up of the data and for the hold time.

However, when the DQS signal is delayed by getting it to pass through a delay line, the delay value is inevitably affected by a certain margin of jitter as a result of the noise present on the power-supply lines, of the temperature gradients, etc.

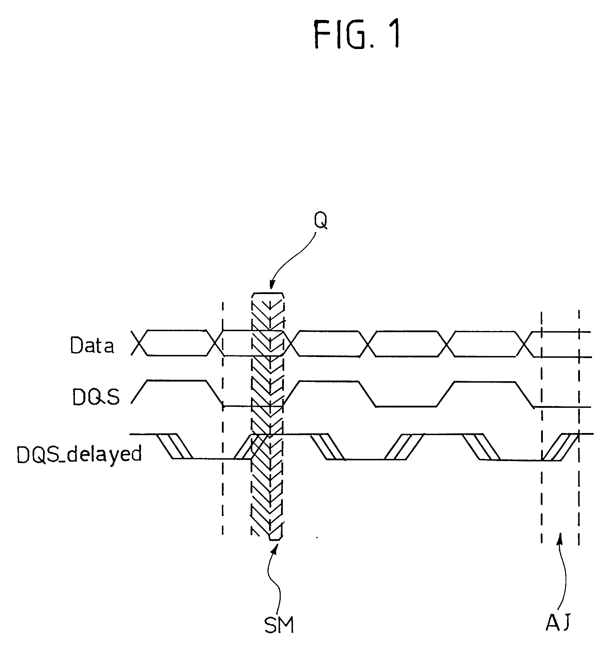

In the timing diagram of Figure 1, the three superimposed diagrams indicate the data signal (Data), the DQS signal (DQS), as well as the delayed DQS signal (DQS_delayed).

The reference SM designates the safety-time margin, whilst the reference AJ designates the added jitter. It will be appreciated that the safety margin SM has been indicated as referring to an amplitude Q corresponding to a quarter of the period of the signals considered.

In this context, there exists the problem of keeping the jitter as low as possible so as to ensure a time margin sufficient for the set-up and the hold time at the synchronization flip-flop.

The range of possible variation in the clock frequency of normal DDR-SDRAM memories may be somewhat wide (e.g., 50-200 MHz): the maximum tolerable amount of jitter must therefore be considered not so much in absolute terms as rather in relation to the frequency (and hence to the period) of operation of the memory, which is a quantity that is subject to variation.

The above requirement does not appear so far to have encountered an adequate response at a technical level, as emerges, for instance, from US-A-6087868, US-A-6125157, and US-A-6140854, as well as from the publication "A Register Controlled Symmetrical DLL for Double Data Rate DRAM", IEEE Journal of Solid State Circuits, Vol. 34, No. 4, April 1999.

For example, US-A-6087868 describes a digital delay-locked loop (DLL) comprising a digital delay line having associated to it a digital phase detector that is able to control the propagation delay of the delay line so as to obtain the synchronization between the internal clock and a reference clock. The DLL loop is open until the internal clock signal and a reference clock-signal edge come to be simultaneously in the phase-detection region. To obtain the locking condition of the DLL, the variable delay is increased starting from a minimum value until the edge of the phase-detection region exceeds the edge considered as reference. Once the DLL loop is closed, a clock-jitter filter is enabled in order to obtain a rejection effect on the jitter associated to the reference clock.

The solution described in US-A-6125157, instead, envisages the use of a chain of delay elements, which receives at input a clock signal. At output from the delay elements there is thus generated a set of phase vectors. The delays of these elements are regulated by a first DLL, whilst a second DLL chooses a pair of phase vectors that embraces the phase of an input clock. By means of a phase interpolator, an output clock signal is then generated, as well as a delayed version of the latter. A phase detector compares the delayed clock signal at output with the clock signal at input and adjusts the phase interpolator so that the delayed clock present at output is in phase with the clock at input.

Finally, the solution described in US-A-6140854 envisages the use of a DLL comprising a delay line, the delay of which can be varied by means of a counter that is incremented to vary the delay. A so-called shifting-delay circuit is present, which operates on the basis of half-periods of a reference clock linked to the source clock. The total delay of the source clock derives from a combination of the action of delay of the aforesaid circuit and of the delay line, the latter occupying areas of silicon that are relatively extensive.

Apart from any other consideration, the above-mentioned solutions prove somewhat complex and burdensome to implement.

### Object and summary of the present invention

The purpose of the present invention is therefore to meet the requirements referred to above in an altogether satisfactory way.

According to the present invention, the above purpose is achieved thanks to a programmable delay line having the characteristics referred to in the ensuing claims. The invention also relates to a storage element (DDR-SDRAM) which incorporates said delay line.

Basically, the solution according to the invention envisages providing a programmable delay line with an added control of the resolution time, with the aim of keeping the jitter proportional to the period of the input signal.

The delay line can be used in a DLL, with the advantage provided by the fact that the resolution (i.e., the jitter) follows the trace of the period of the input signal. Given that the frequency rate of the DLL at which the system operates depends upon the resolution, a wider working frequency is obtained by keeping a satisfactory time margin.

The solution according to the invention enables, in particular, implementation of a DLL capable of working in a wide range of frequencies (50-200 MHz), which may be used for the majority of DDR-SDRAM storage devices available on the market.

### Detailed description of the annexed drawings

The present invention will now be described, purely by way of non-limiting example, with reference to the attached drawings, in which:
- Figure 1, which is aimed at enabling definition of the problem underlying the present invention, has already been described previously; and
- Figures 2 and 3 illustrate, in the form of circuit block diagrams, two possible different embodiments of the solution according to the invention.

### Detailed description of some examples of embodiment of the invention

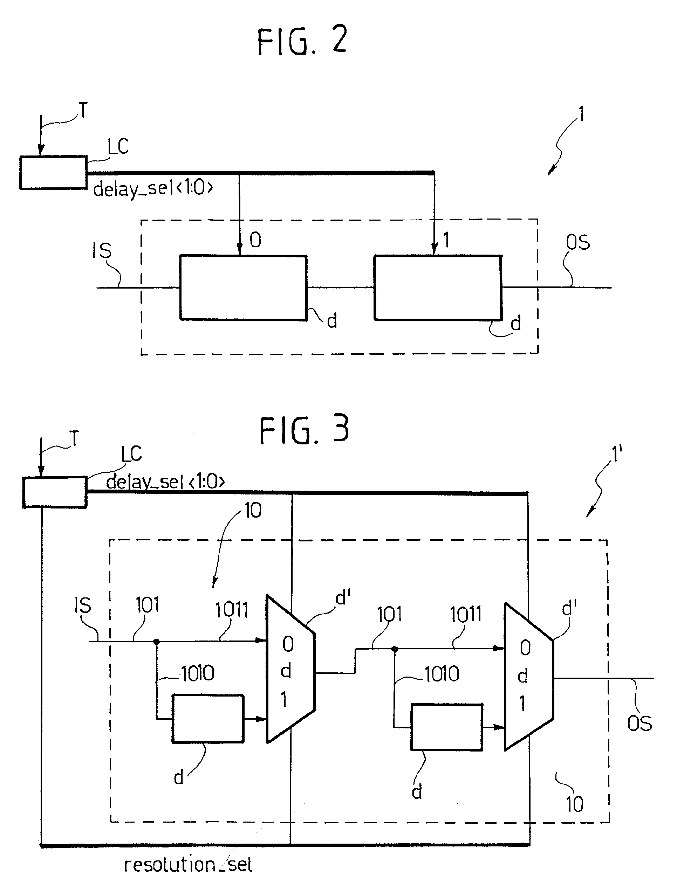

Both the diagram of Figure 2 and the diagram of Figure 3 illustrate the structure of a delay line 1 (in Figure 2) and 1' (in Figure 3) designed to perform its function on an input signal IS so as to generate an output signal OS delayed by a pre-determined time interval.

With specific reference to the preferred (but not imperative) application to which reference has been made in the introductory part of this description, the input signal IS is constituted by the DQS signal, whilst the output signal OS is constituted by the delayed DQS signal DQS_delayed.

With a view to the said application, the invention stems from the observation that the safety margin for the data set-up and the hold time at the synchronization flip-flop depends upon the difference between the value of one quarter of period QP of the DQS signal and the added jitter AJ added in the delayed DQS signal.

Consequently, for a fixed jitter value, the safety margin is reduced as the period of the DQS signal is reduced.

In order to maintain the safety margin within a desired range as the period of the DQS signal varies, it is possible to control the jitter in view of the fact that the latter depends, proportionally, upon the resolution of the delay line.

The solution according to the invention consequently envisages implementation of a programmable delay line with a function of additional control so as to be able to adjust the time resolution (and hence the jitter) and keep the latter proportional to the period of the DQS signal.

The main advantage of this implementation is provided by the fact that (with reference to the application to a DDR-SDRAM) the resolution can follow the period of the DQS signal. Given that the range of frequencies of operation of the DLL depends upon the resolution, it is possible to obtain a wider range of frequencies of operation, at the same time maintaining a reasonable safety margin.

In both of the solutions illustrated in Figures 2 and 3, the use is envisaged, in the framework of a DLL, of a delay line 1, 1', respectively, subjected to a control logic LC capable of generating:
- a first logic signal called delay_sel, and
- in the case of the embodiment of Figure 3, a second logic signal called resolution_sel.

From the ensuing more detailed illustration it will be appreciated that the solution according to the invention is, by its intrinsic nature, of a modular type. This solution enables, in fact, generation, starting from individual delay modules d (which retard the signal brought to their inputs by an amount equal to the value d), of a maximum delay value. In the case of the embodiment of Figure 2, this maximum delay corresponds to 2d (with a resolution factor ±r, where r denotes the resolution or jitter). In the case of the embodiment illustrated in Figure 3, the delay in question is respectively equal to 2d or 4d with a resolution margin that continues to be ±r, and hence, virtually, with a doubling of the delay that does not increase the jitter.

In actual fact, the jitter varies as the delay time varies. The solution according to the invention envisages, more precisely, making the jitter vary proportionally to the clock period.

The solution according to the invention ensures that, for short clock periods (high operating frequencies) a low jitter is obtained, and for longer clock periods (low operating frequencies) a proportionally higher jitter is obtained.

The jitter depends, in fact, upon the power supply noise and upon the thermal gradients that are largely invariant with respect to the delay time, as well as upon the resolution of the individual delay module, all these being factors that depend exclusively upon the module itself.

The architecture of the delay module is designed in such a way as to give rise to a jitter that adapts to the frequency of the system in such a way as to maintain the period/jitter ratio constant.

It is, on the other hand, evident that the same principle illustrated here can be extended to even greater delay values than the values 2d and 4d, here cited purely by way of example. This result can be obtained, for instance, using a larger number of individual delay elements d and modifying accordingly the control logic LC, so as to give rise to output signals that express more complex logical combinations.

In the case of the delay line 1 of Figure 2, the values assumed by the signal delay_sel enable selective activation of one or both of the delay elements d.

In particular, in the case of the proposed application to a DDR-SDRAM memory, this can be done according to a signal T which indicates the value of the period (and hence of the frequency) of operation of the memory supplied to the control logic LC.

To a halving of the operating period there can thus correspond a halving of the total delay value imparted to the signal IS.

This flexibility of operation is further developed in the case of the embodiment of Figure 3, where the delay line 1' is constituted by the cascading of two homologous delay units, designated by 10. Each unit 10 comprises an input line 101, which is doubled on a first branch 1010, which functions as input for a delay module d, and on another branch designated by 1011, which goes to a first input of a delay module d' of a combinatorial type (it may, for instance, simply be a flip-flop), provided with another input to which the signal at output from the delay module d referred to previously is brought.

Each module d' is configured in such a way that, if the signal resolution_sel has a logic value 0, the element d' behaves simply like a delay line (with a delay value which will here be assumed simply as being equal to d even though at least in principle the value could be other than d).

In this case, the delay line 1' behaves (according to the value assumed by the signal delay_sel) in the same way as the delay line 1 described previously with reference to Figure 2.

If, instead, the signal resolution_sel assumes the logic value 1, then each one of the units 10 behaves in practice as the cascading of two delay modules with a total delay value equal to 2d (it is, in fact - in the framework of each element 10 - the delay deriving from the sum of the delay imparted by the module d to the signal brought onto the line 1010 and of the additional delay - also this assumed as being equal to d - applied to the same signal by the element d').

As has already been said, in this case the total delay value can be brought up to a value equal to 4d, maintaining, however, the resolution value ±r, this in so far as the main sources of jitter (the noise present on the power supply and the temperature gradients) affect the circuit in the same way irrespective of the delay value attained.

Of course, without prejudice to the principle of the invention, the details of construction and the embodiments may vary widely with respect to what is described and illustrated herein, without thereby departing from the scope of the present invention as defined in the ensuing claims.

## Claims

1. A programmable delay element, **characterized in that** it comprises:
- a plurality of delay modules (d, d'), which can be connected together for generating, starting from an input signal (IS), an output signal (OS) delayed with a pre-determined time-delay value referred to a given value (T) of operating period; said delayed output signal being affected by jitter (AJ); and
- a control logic (LC) for selectively connecting together the delay modules (d, d') of said plurality in such a way as to obtain said value of pre-determined time delay referred to a given value (T) of operating period as a result of connection of said modules (d, d'); the arrangement being such as to cause said jitter to vary proportionally to said operating period (T) so as to maintain the ratio between said period (T) sand said jitter substantially constant.

2. The element according to Claim 1, **characterized in that** said control logic (LC) generates at least one first control signal (delay_sel) to identify selectively the delay modules (d, d') of said plurality that are activated.

3. The element according to Claim 2, **characterized in that** said delay modules are arranged in a plurality of pairs (d, d'), and **in that** said control logic (LC) is able to generate also a second logic signal (resolution_sel) for determining, within each pair of said delay modules (d, d') activated as a result of emission of said at least one first logic signal (delay_sel), selective activation of one or of both of the delay modules (d, d') comprises in the pair.

4. The element according to Claim 3, **characterized in that** in said pair, one (d') of the delay elements carries, associated thereto, a combinatorial function driven by said second logic signal (resolution_sel).

5. A memory, such as a memory of the DDR-SDRAM type, provided with a function for generating a delayed DQS signal (DQS_delayed), **characterized in that** it comprises a delay element according to any one of Claims 1 to 4 for generating a version (DQS_delayed) of said DQS signal delayed by a pre-determined amount of time, and **in that** said delay element is configured in such a way that said pre-determined amount of time is varied with reference to said given value (T) of operating period, the latter given value being identified by the frequency of operation of the memory.

6. The memory according to Claim 5, **characterized in that** said predetermined amount of time is substantially equal to one quarter (90°) of said given value (T) of operating period.
